# EUROPEAN PATENT APPLICATION

(11) **EP 4 492 935 A1**
(43) Date of publication of application: **15.01.2025**
(21) Application number: 24187475.9
(22) Date of filing: 09.07.2024
(51) Int. Cl.: H05K 7/20

(54) **ELECTROWETTING AND THERMOELECTRICS ASSISTED TWO PHASE COOLING OF POWER ELECTRONICS USING INTEGRATED COOLING**

(30) Priority: 10.07.2023 US 202318349482
(71) Applicant: Hamilton Sundstrand Corporation, Charlotte, NC 28217-4578 (US)
(72) Inventor: PAL, Debabrata, Hoffman Estates, 60192 (US); KILCHYK, Viktor, Lancaster, 14086 (US)
(74) Representative: Dehns

(57) **Abstract**

Disclosed herein is a two-phase cooling electrowetting thermosyphon assembly and method of use thereof. The two-phase cooling electrowetting thermosyphon assembly provides cooling in the absence of gravity and/or in variable orientations of gravitational forces. The assembly combines a thermosyphon (101) with an electrowetting electrode (105) and a condenser (109). In certain embodiments, a Peltier cooler (124) is incorporated into the assembly.

## Description

### BACKGROUND

Aircraft power conversion systems and motor controllers can be cooled by single phase liquid and air cooling. Liquid cooling can be advantageous for higher power (e.g., greater than 60 kilowatts) motor controllers, however liquid cooling increases system complexity. Thermosyphons can be used to provide system cooling. Generally, thermosyphon based systems use gravity to complete the cooling loop. However, for various system orientations the gravity based cooling mechanism of the thermosyphon can be inoperable. Because of the reliance of thermosyphon systems on gravitational forces, the applications of thermosyphons are limited.

Therefore, the need remains for effective, thermosyphon cooling for variable orientations of gravitational forces.

### SUMMARY

An electrowetting thermosyphon assembly comprises a liquid, a vapor, a thermosyphon, a condenser, and an electrowetting electrode. The thermosyphon is operative to contain a two-phase coolant comprising the liquid and the vapor. The condenser is in fluid communication with the two-phase coolant and is operative to cool the vapor within the thermosyphon. The electrowetting electrode is operative to provide a driving voltage for electrowetting of the liquid downstream of the condenser within the interior of the thermosyphon.

In one embodiment, the two phase coolant is transported within conduits within the thermosyphon.

In another embodiment, the condenser is a heat sink with a finned area to facilitate heat dissipation.

In yet another embodiment, forced air flows over the condenser as part of a cooling process.

In yet another aspect, the assembly further comprises a pump to transport the two phase coolant within the thermosyphon.

In yet another aspect, the assembly further comprises a heat generating electronic component disposed on the exterior surface of the thermosyphon where the area of the thermosyphon heated by the heat generating electronic component is an evaporator area.

In yet another embodiment, the evaporator area, the condenser, and the electrowetting electrode are arranged in a recycle loop.

In yet another embodiment, the electronic component is disposed on a thermally conductive gap filler pad.

In yet another embodiment, the assembly further comprises a Peltier cooler operative to cool the heat generating electronic component wherein the Peltier cooler is disposed between the thermosyphon and the heat generating electronic component.

In yet another embodiment, the assembly further comprises a Peltier cooler operative to generate power from the heat generating electronic component wherein the Peltier cooler is disposed between the thermosyphon and the heat generating electronic component.

In yet another embodiment, the assembly further comprises a wick structure where the wick structure serves to transport the liquid to the evaporator surface.

A method of cooling electronic components using an electrowetting thermosyphon assembly comprises introducing heat into the assembly from a heat generating electronic component disposed on a surface of a thermosyphon. The area of the thermosyphon heated by the heat generating electronic component is an evaporator area. A two phase coolant comprises a liquid and a vapor and is contained within the thermosyphon. The two phase coolant is passed over the evaporator area and at least a portion of the two phase coolant is evaporated.

In one embodiment of the method of cooling electronic components, the liquid discharged from the electrode is discharged to the evaporator area of the thermosyphon.

In another embodiment, the method of cooling electronic components further comprises cooling the evaporator area with a Peltier cooler disposed between the heat generating electronic component and the thermosyphon.

A method of generating power from a heat generating electronic component using an electrowetting thermosyphon assembly comprises introducing heat into the assembly from a heat generating electronic component disposed on a surface of a Peltier cooler. The Peltier cooler is disposed on a thermosyphon. The area of the thermosyphon heated by the heat generating electronic component disposed on the Pelter cooler comprises an evaporator area. A two phase coolant comprises a liquid and a vapor and is contained within the thermosyphon. The two phase coolant is passed over the evaporator area and at least a portion of the two phase coolant is evaporated. The vapor is discharged from the evaporator area into a condenser. The vapor is condensed within the condenser into a liquid. The liquid is discharged downstream of the condenser via an electrowetting electrode. The heat from the heat generating electronic components is used to generate electricity from the Peltier cooler.

In one embodiment of the method of generating power from a heat generating electronic component, the electricity generated from the Peltier cooler is used to maintain the temperature at the base of the heat generating electronic component.

The above described and other features are exemplified by the following figures and detailed description.

### BRIEF DESCRIPTION OF THE DRAWINGS

Referring now to the figures, which are exemplary embodiments, and wherein the like elements are numbered alike.
FIG. 1 is a schematic of an embodiment of an exemplary two-phase cooling electrowetting thermosyphon assembly; and
FIG. 2 is a schematic of an alternative embodiment of an exemplary two-phase cooling electrowetting thermosyphon assembly.

### DETAILED DESCRIPTION

Disclosed herein is an electrowetting thermosyphon assembly and methods of use thereof. The electrowetting thermosyphon assembly can be used for cooling of power electronics. The electrowetting thermosyphon assembly provides cooling in the absence of gravity and/or in variable orientations with respect to gravitational forces. The assembly combines a thermosyphon with an electrowetting electrode and a condenser. Further disclosed is an electrowetting thermosyphon assembly for cooling of power electronics including at least one Peltier cooler. In some embodiments, the Peltier cooler can be used in power generation mode.

The design of the assembly comprises a thermosyphon containing a two phase coolant. The thermosyphon can be in contact with heat-generating electronic components such as power modules and magnetic components. Heat generated by the electronics evaporates at least a portion of the two phase coolant within the thermosyphon into vapor. The vapor flows to a condenser. The condenser condenses the vapor into liquid. The liquid is transported across the inner surface of the thermosyphon by electrowetting to complete the cooling loop. The cooling cycle can be repeated. In certain embodiments, a Peltier cooler is disposed between a heat-generating electronic component and the thermosyphon to facilitate a temperature decrease at the interface between the thermosyphon and the electronic component. In further embodiments, the Peltier cooler can be used in power generation mode to generate electricity from the heat-generating electronic component.

"Electrowetting," as used herein, is defined as the decrease in the contact angle of a liquid on a solid surface when a driving voltage is applied to an interface of the solid and the liquid.

"Subambient temperature," as used herein, refers to a temperature less than the temperature of a surrounding environment.

"And/or," as used herein, means "and" or "or." For example, a composition comprising A, B and/or C is interpreted to mean that the composition includes A, B, C or any combination of A, B and C including AB, BC, AC and ABC.

"Hydrophobic," as used herein, is defined as a material with a water contact angle of greater than 90° as measured by ASTM D7334.

"Peltier effect," as used herein, is defined as when a temperature difference is generated between the junctions of two different types of materials in a thermocouple by applying electricity across the two different types of materials.

"Seebeck effect," as used herein, is defined as when electricity is created between the junctions of two different types of materials in a thermocouple by applying a temperature difference across the two different types of materials.

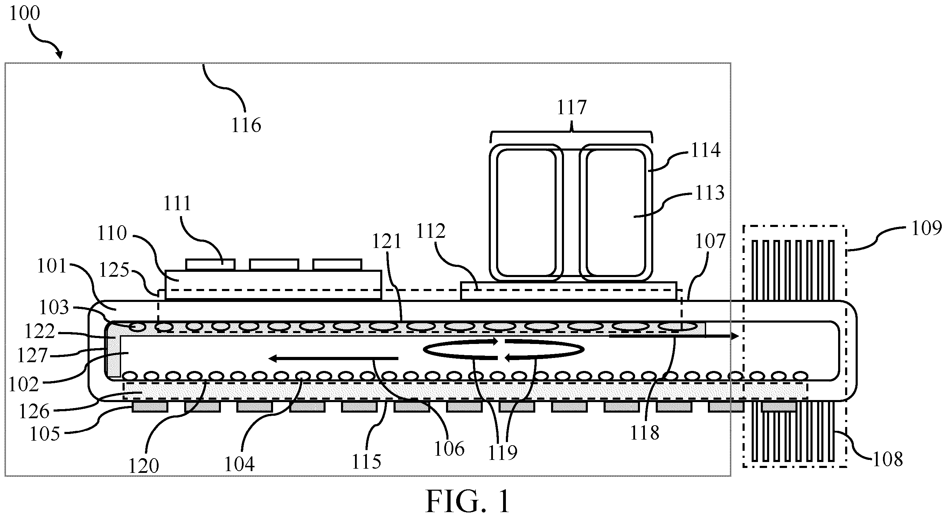

FIG. 1 depicts an exemplary two-phase cooling electrowetting thermosyphon assembly 100 (hereinafter assembly 100) that comprises a thermosyphon 101, a condenser 109, and an electrowetting electrode 105. As shown in FIG. 1, electronic components such as a power module 111 and a magnetic component 117 can be disposed on a surface 107 of the thermosyphon 101. A condenser 109 is downstream of the electronic components on the thermosyphon 101. One or more electrowetting electrodes 105 are disposed on the surface 115 of the thermosyphon 101. The thermosyphon 101 has an interior space 102 with a two phase coolant. The coolant includes a vapor 103 and a liquid 104. The vapor 103 flows to the condenser 109 in the direction indicated by arrow 118. The condenser 109 condenses the vapor 103 into the liquid 104. The liquid 104 flows downstream of the condenser 109 along the interior surface 120 of the thermosyphon 101. One or more electrowetting electrodes 105 facilitate the flow of the liquid 104 within the thermosyphon 101 via an electrowetting process. The liquid 104 is transported along the interior surface 120 of the thermosyphon 101 in the direction indicated by arrow 106. The liquid 104 can flow within a wick structure 122 from the interior surface 120, along an interior surface 127, to an opposing evaporator surface 121, and along the evaporator surface 121. The liquid 104 is then evaporate into vapor 103 by the heat generating electronic components along the surface 107 of the thermosyphon. The vapor 103 flows within the interior space 102 of the thermosyphon 101, within the wick structure 122, and/or along the interior surfaces of the thermosyphon 101. The vapor 103 flows to the condenser 109 and the cooling cycle continues.

The electronic components, the condenser 109, and the electrowetting electrode 105 lie in a recycle loop as indicated by the arrows 119. A recycle loop is one where each component of the loop can be both upstream and downstream of any other component in the loop. The condenser 109 is both upstream and downstream of the electrowetting surface 120 activated by the driving voltage of the electrowetting electrode 105 because the liquid 104 discharged from the condenser 109 is fed to the interior surface 120 where the liquid 104 is transported by electrowetting of the electrowetting electrode 105, while at the same time liquid 104 flows to the evaporator surface 121 of the thermosyphon 101 within a wick structure 122 where the liquid 104 is evaporated by heat generated by electronic components into the vapor 103 that flows to the condenser 109 where it is condensed into the liquid 104. The evaporator area 125 of the thermosyphon 101 includes the portion of the heat sink of the thermosyphon 101 that is heated by the electronic components.

Within the assembly 100, a two phase coolant is in fluid communication with a condenser 109. The condenser 109 facilitates the condensation of a vapor 103 to a liquid 104. In an embodiment, the condenser 109 is a heat sink with a finned area to facilitate thermal diffusion. In some embodiments, forced air flows over the condenser during the cooling process. The forced air can be supplied by a fan or physical movement of the assembly 100.

The thermosyphon 101 can comprise an enclosed interior space 102 where the two phase coolant comprising the vapor 103 and the liquid 104 have two phase mixing during the cooling cycle. In other embodiments, the thermosyphon 101 can comprise a closed loop wherein the vapor 103 and the liquid 104 are transported within conduits of the closed loop during the cooling cycle.

At least one electrowetting electrode 105 can be disposed on the surface 115 of the thermosyphon opposing the surface where one or more electronic components are disposed on the thermosyphon 101. In some embodiments, an electrowetting electrode can be integrated into the thermosyphon surface.

One or more electronic components can be disposed directly on the surface 107 of the thermosyphon. As shown in the figures, the electronic components can include a power module 111 and or a magnetic component 117. In alterative embodiments, one or more electronic components can be disposed onto a thermally conductive gap filler pad, labeled as 110 and 112 in the figures. The one or more electronic components can generate heat, which can be transmitted to the thermosyphon to facilitate evaporation of the liquid 104 to vapor 103. In some embodiments, the electronic components can be integrated into the thermosyphon surface and contact it directly.

The assembly 100 can be a line replaceable unit which can be removed and replaced during equipment maintenance. In some embodiments, the assembly 100 can be partially or fully enclosed in a housing 116 as shown in the figures.

The assembly 100 can comprise a single, enclosed interior space 102. In other embodiments, the assembly 100 can comprise one or more streams to transport the vapor 103 and the liquid 104. The one or more streams to transport the two phase coolant can be solely within the condenser 109 of the assembly 100 and/or throughout the interior space 102 of the thermosyphon 101. In some embodiments, the assembly 100 can include one or more pumps to facilitate the transport of the two phase coolant through one or more streams.

The thermosyphon 101 serves as a heat sink for the heat generating electronic components and containment system for the two phase coolant comprising of the vapor and the liquid. The thermosyphon 101 can be comprised of a combination of materials including stainless steel, titanium, dielectric materials and hydrophobic materials. In some embodiments, the interior surfaces of the thermosyphon 101 are coated with inert materials such as a hydrophobic coating. Suitable hydrophobic coatings include polytetrafluoroethylene, polydimethylsiloxane, polyethylene terephthalate, polypropylene, and so forth.

The two phase coolant comprising a vapor 103 and a liquid 104 comprises a refrigerant capable of undergoing repeated phase transitions and is additionally suitable for electrowetting applications. Suitable coolants include water, aqueous solutions, and polar solvents. The vapor 103 and the liquid 104 facilitate the cooling cycle by absorbing heat from the electronic components and transferring the heat to the condenser 109 for dissipation. In some embodiments, additives can be combined with the vapor 103 and the liquid 104 to facilitate phase transfer, reduce corrosion, reduce the freezing point of the liquid, and so forth. Suitable additives for the two phase coolant include salts, alcohols, and so forth.

The condenser 109 provides cooling of the vapor 103 within the thermosyphon 101. The condenser 109 can be a passive or an active heat sink. In some embodiments, the condenser 109 includes a heat sink finned area 108 as shown in the figures. The condenser 109 can be air cooled, water cooled, or cooled via other suitable mechanisms. The condenser 109 can be composed of materials with good thermal conductivity of greater than 50 watts per meter kelvin (W/m-K) to about 3000 W/m-K as measured by ASTM C177. Examples of suitable materials for the condenser 109 include aluminum and copper.

An electrowetting electrode 105 can be disposed on the surface 115 of the thermosyphon or integrated therein. The electrowetting electrode 105 serves to provide a driving voltage for electrowetting across the surface 120 of the thermosyphon. The electrowetting electrode 105 facilitates the flow of the liquid 104 downstream of the condenser 109. This electrowetting assisted process enables the thermosyphon 101 to cool the electronic components in any orientation. Due to the electrowetting action of an electrowetting electrode 105, cooling can be continuously performed even when there are changes to the orientation of the assembly 100 during use.

The electrowetting electrode 105 can be incorporated into a suitable configuration to facilitate electrowetting across the surface 120. In some embodiments, the electrowetting electrode 105 can be disposed upon or integrated into one or more materials. The electrowetting electrode 105 can be disposed fully or partially on an insulator or a dielectric layer disposed on the surface 115. In some embodiments, the dielectric layer and/or the insulator layer can be integrated into the surface 115 of the thermosyphon and contact it directly or indirectly. In some embodiments, the dielectric layer and/or the insulator layer can form the wall 126 of the thermosyphon 101, forming both the surface 120 and the surface 115. In further embodiments, the electrowetting electrode can be disposed on a combination of an insulator and a dielectric material disposed on the surface. The dielectric layer and/or the insulator layer can be disposed between the electrowetting electrode 105 and the liquid 104 to prevent electrolysis of the liquid 104 by effectively blocking charge transfer at the liquid/electrode interface. The insulator layer can have a resistivity of about 10⁻⁷ to about10⁻¹⁶ ohms centimeters (ohm-cm) as measured by ASTM D257. Suitable insulator materials include polyvinyl chloride, polyethylene, silicone, and combinations thereof. The dielectric layer can be comprised of a material capable of developing an internal electric field with a relative dielectric constant in a range of about 1 to about 5 as measured by ASTM D150. Suitable dielectric materials include a ceramic, silica, a plastic, a metal oxide, or combinations thereof.

The wick structure 122 within the thermosyphon 101 can be disposed along the interior surface 127 of the thermosyphon and the evaporator surface 121 of the thermosyphon. In some embodiments, the wick structure 122 is disposed fully or partially along the evaporator surface 121. In some embodiments, the wick structure 122 is not present. The wick structure 122 facilitates the transport of the liquid 104 from the interior surface 120 of the thermosyphon 101 to the opposing evaporator surface 121. Wicking within the wick structure 122 can occur via absorption, capillary action, or both. The wick structure 122 can be a bi-porous wick, a grooved wick, a nano-layered wick, a composite wick, an additively manufactured wick, and combinations thereof. The wick structure 122 can comprise a wicking material. The wicking material can be hydrophilic. Suitable wicking materials for the wick structure can include porous material such as ceramics, electrodeposited metal wicks, nanocarbon foams, silicas, sintered metal fiber wicks, sintered metal powder wicks, zeolites, woven or non-woven textiles and combinations thereof.

The interior surface 102 of the thermosyphon 101 can comprise a hydrophobic layer disposed on the surface 120. In some embodiments, a dielectric material is between the electrowetting electrode 105 and the hydrophobic layer. In some embodiments, the electrowetting electrode 105 is disposed on a combination dielectric layer and hydrophobic layer. The hydrophobic layer can serve to reduce the applied voltage to actuate the liquid 104 across the surface 120 of the thermosyphon 101. The hydrophobic layer can be roughened to increase hydrophobicity. Suitable hydrophobic materials include polytetrafluoroethylene, polydimethylsiloxane, polyethylene terephthalate, polypropylene, and the like.

The heat generating electronic components to be cooled can include a power module 111 and a magnetic component 117. The magnetic component 117 can be comprised of winding 114 and a core 113 as shown in the figures. In some embodiments there is at least one or more electronic components within the assembly 100. As shown in the figures, the area of the thermosyphon 101 heated by the electronic components serves as the evaporator area 125 of the cooling system where the heat from the electronic components provides the energy to evaporate the liquid 104 into vapor 103.

In some embodiments, the electronic components can be disposed upon a thermally conductive gap filler pad (hereinafter pad), labeled as 110 and 112 in the figures. Suitable thermally conductive gap filler pad materials include mixtures of silicone, ceramics, carbon fibers, and so forth. The pad can be in a solid, a gel, or a putty form. When present, the thermally conductive gap filler pad can serve to conform to the components and fill gaps between the heat generating electric component and the heat sink of the thermosyphon.

In some embodiments, an electronic component can be disposed upon a thermoelectric "Peltier" cooler. In further embodiments, the electronic component can be disposed upon a thermally conductive gap filler pad and the pad can be disposed upon a Peltier cooler, where the pad can serve to conform to the components and fill gaps between the heat generating electric component and the Peltier cooler.

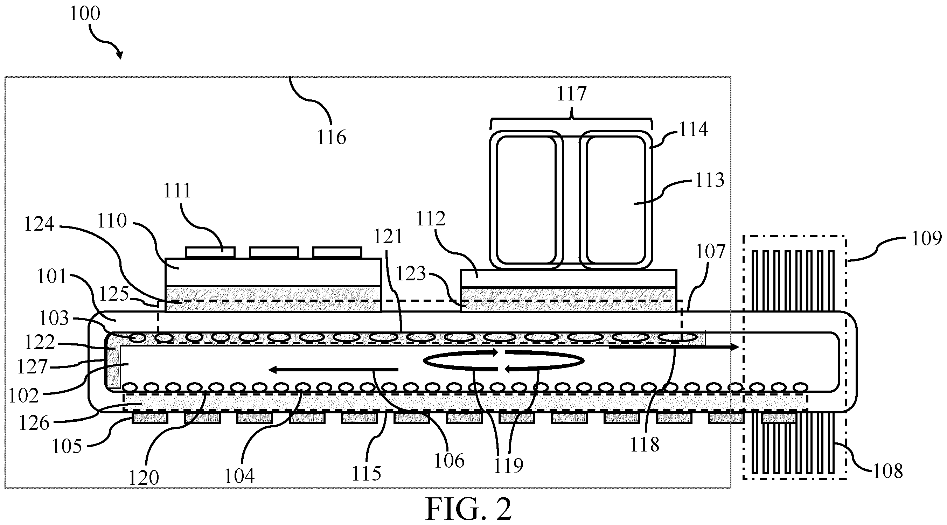

FIG. 2 depicts an exemplary assembly 100 further including a Peltier cooler 123 and a Peltier cooler 124. As shown in FIG. 2, a Peltier cooler can be disposed between a heat generating electronic component and the thermosyphon 101. The Peltier cooler can be powered by electricity and used in refrigeration mode and/or power generation mode. The Peltier cooler can be switched between refrigeration mode and power generation mode by reversing the polarity of the flow of electricity through the cooler. The Peltier cooler operates via the Peltier effect when in refrigeration mode and via the Seebeck effect in power generation mode. The Peltier cooler can serve to facilitate the cooling of an electronic component. In some embodiments, the Peltier cooler can be used to cool the junction between the electronic component and the thermosyphon 101. In other embodiments, the Peltier cooler can be used to cool the junction between the thermally conductive gap filler pad and the thermosyphon 101. In some embodiments, the Peltier cooler can cool an electronic component to a temperature that is less than the surface temperature of the thermosyphon 101.

In certain embodiments, when the ambient temperature is less than about 10°C, a Peltier cooler disposed between an electronic component and the thermosyphon 101 within the assembly 100 can generate electricity. Under conditions where electricity is generated by the Peltier cooler via the Seebeck effect, the temperature at the junction between the Peltier cooler and the electronic component is converted to additional power. For the assembly configuration exemplified in FIG. 2, the use of the Peltier cooler 124 and the Peltier cooler 123 in a refrigeration mode provides a reduction of temperature for both the bases of the electronic components and the junctions between the electronic components and the thermosyphon 101. For the assembly configuration exemplified in FIG. 2, the use of the Peltier cooler 124 and the Peltier cooler 123 in power generation mode, when the ambient air temperatures of less than 10 °C, provides maintained and consistent temperatures for both the bases of the electronic components and the junctions between the electronic components and the thermosyphon 101. Furthermore, the assembly configuration in FIG. 2 in power generation mode, provides added power via the Seebeck effect. Added power from the Peltier cooler can provide at least some of the driving voltage for the electrowetting process.

Multiple Peltier coolers can be used in combination as a multi-stage module. The multi-stage module can be stacked or in a cascade to facilitate cooling and/or power generation. Multiple and/or multiple types of Peltier coolers can be used in the multi-stage module. One or more multi-stage modules of Peltier coolers can be used in the assembly.

Suitable semiconductors for use within the Peltier coolers include bismuth telluride, lead telluride, silicon-germanium, and bismuth antimony alloys.

The assembly 100 provides the capability to cool electronic components with a thermosyphon 101 including an electrowetting process. Inclusion of an electrowetting process facilities the cooling function in any gravitational orientation. Further embodiments provide increased cooling efficiency by the addition of at least one Peltier cooler to the assembly 100.

The disclosed assembly provides a cooling system without a complex liquid cooling loop. The liquid movement within the thermosyphon 101 has improved efficiency of the cooling cycle due to the controlled flow of the liquid 104 away from the condenser 109 via an electrowetting process. The disclosed assembly 100 further provides cooling in variable orientations due to the electrowetting process. Thermoelectric "Peltier" coolers can be disposed between the heat generating electronic components and the thermosyphon 101 to increase the cooling exerted by the thermosyphon 101 on electronic components. The Peltier coolers can also be used to produce electricity. When the Peltier coolers are used in power generation mode, the power generated can be applied to maintain the temperatures at the base of an electric component, at the junction of an electric component and the thermosyphon, and/or at the junction of a thermally conductive gap filler pad and the thermosyphon.

While the disclosure has been described with reference to a preferred embodiment, it will be understood by those skilled in the art that various changes can be made without departing from the scope of the invention as defined by the claims. In addition, many modifications can be made to adapt a particular situation or material to the teachings of the disclosure without departing from scope of the claims.

## Claims

1. An electrowetting thermosyphon assembly comprising:
a liquid (104);
a vapor (103);
a thermosyphon (101) that is operative to contain a two phase coolant comprising the liquid and the vapor;
a condenser (109) that is in fluid communication with the two phase coolant and is operative to cool the vapor within the thermosyphon; and
an electrowetting electrode (105) that is operative to provide a driving voltage for electrowetting of the liquid downstream of the condenser within an interior of the thermosyphon.

2. The assembly of claim 1, wherein the two phase coolant is transported within conduits within the thermosyphon (101).

3. The assembly of claim 1 or 2, wherein the condenser (109) is a heat sink with a finned area (108) to facilitate heat dissipation.

4. The assembly of any preceding claim, wherein forced air flows over the condenser (109) as part of a cooling process.

5. The assembly of any preceding claim, further comprising a pump to transport the two phase coolant within the thermosyphon.

6. The assembly of any preceding claim, further comprising a heat generating electronic component disposed on the exterior surface of the thermosyphon wherein an area of the thermosyphon heated by the heat generating electronic component is an evaporator area (125).

7. The assembly of claim 6, wherein the evaporator area, the condenser and the electrowetting electrode are arranged in a recycle loop.

8. The assembly of claim 6, wherein the heat generating electronic component is disposed on a thermally conductive gap filler pad (110, 112).

9. The assembly of claim 6, wherein the assembly further comprises a Peltier cooler (124) operative to cool the heat generating electronic component wherein the Peltier cooler is disposed between the thermosyphon and the heat generating electronic component or wherein the assembly further comprises a Peltier cooler operative to generate power from the heat generating electronic component wherein the Peltier cooler is disposed between the thermosyphon and the heat generating electronic component.

10. The assembly of any preceding claim, wherein the assembly further comprises a wick structure (122), wherein the wick structure serves to transport the liquid to the evaporator surface.

11. A method of cooling electronic components using an electrowetting thermosyphon assembly comprising:
introducing heat into the thermosyphon assembly from a heat generating electronic component disposed on a surface of a thermosyphon (101), wherein the area of the thermosyphon heated by the heat generating electronic component is an evaporator area;
passing a two phase coolant contained within the thermosyphon over the evaporator area (125) and evaporating at least a portion of the two phase coolant into a vapor (103), wherein the two phase coolant comprises a liquid (104) and a vapor;
discharging the vapor from the evaporator area into a condenser (109);
condensing the vapor within the condenser into a liquid;
discharging the liquid downstream of the condenser via an electrowetting electrode (105).

12. The method of claim 11, wherein the liquid discharged from the electrowetting electrode is discharged to the evaporator area of the thermosyphon.

13. The method of claim 11, further comprising cooling of the evaporator area with a Peltier cooler (124) disposed between the heat generating electronic component and the thermosyphon.

14. A method of generating power from a heat generating electronic component using an electrowetting thermosyphon assembly comprising:
introducing heat into the assembly from a heat generating electronic component disposed on a surface of a Peltier cooler (124), wherein the Peltier cooler is disposed on a thermosyphon (101);
and the area of the thermosyphon heated by the heat generating electronic component disposed on the Peltier cooler disposed on the surface of the thermosyphon comprises an evaporator area;
passing a two phase coolant contained within the thermosyphon over the evaporator area (125) and evaporating at least a portion of the two phase coolant into a vapor (103), wherein the two phase coolant comprises a liquid (104) and a vapor;
discharging the vapor from the evaporator area into a condenser (109);
condensing the vapor within the condenser into a liquid;
discharging the liquid downstream of the condenser via an electrowetting electrode (105);
wherein the heat from the heat generating electronic components is used to generate electricity from the Peltier cooler.

15. The method of claim 14, wherein the electricity generated from the Peltier cooler is used to maintain the temperature at the base of the heat generating electronic component.
